# EUROPEAN PATENT APPLICATION

(11) **EP 1 691 594 A1**
(43) Date of publication of application: **16.08.2006**
(21) Application number: 05100908.2
(22) Date of filing: 09.02.2005
(51) Int. Cl.: H05K 7/02, H05K 7/10

(54) **Chip assembling structure and socket**

(71) Applicant: OPTIMUM CARE INTERNATIONAL TECH INC., Neihu District, Taipei City 114 (TW)
(72) Inventor: Lien, Jefrey, Shihlin District 111, Taipei City (TW)
(74) Representative: Benatov, Emil Gabriel

(57) **Abstract**

The present invention relates to the design of a chip assembling structure and socket, namely a chip assembling structure that allows various semiconductor chips, which contain multiple contacts (11) and integrated circuit elements, to form a chip receiving structure along with a socket (2) that could be randomly assembled or disassembled; wherein, said socket (2) consists of either a single or a combination of insulating housings with at least one receiving face (21) that contain the contact ends (221) of multiple transition media (22) for matching the contacts (11) of the chips (1), and extend each transition medium (22) to form soldering terminals (or plug terminals) (222) on the pre-selected surface of the socket (2) ; thereby enabling any assembling and disassembling application along with semiconductor chips.

## Description

### FIELD OF THE INVENTION

The present invention is related to the design of a chip assembling structure and socket, specifically, to a design that can be widely applied in memory (such as DRAM, SRAM, SDRAM, Flash, DDR, or Rambus) chips, microprocessor, logical or RF(Radio Frequency) chips; and related to the design of the assembling structure and socket of the chip.

### DESCRIPTION OF PRIOR ART

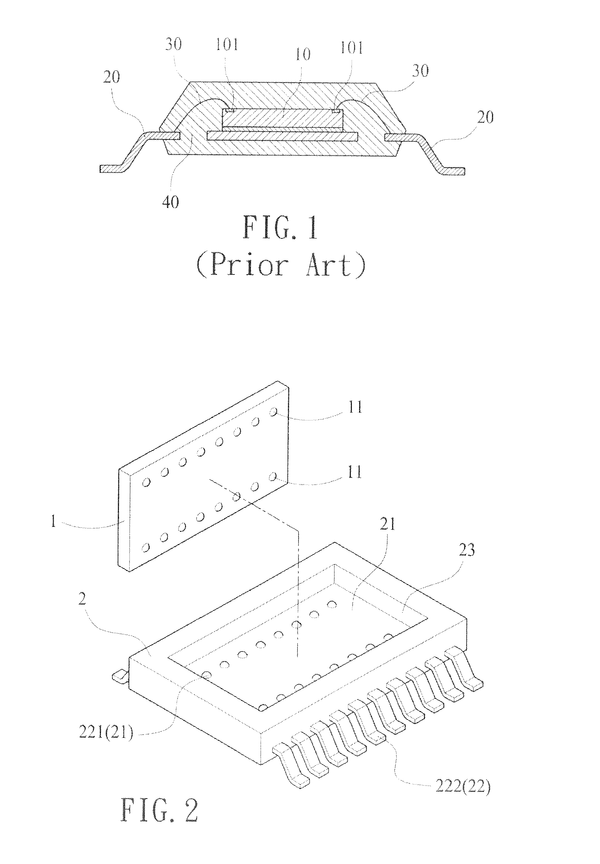

Traditionally, a semiconductor chip cut from a wafer will set a plurality of soldering points and integrated circuit elements on its selected surface. If the chip is to be applied in an electrical apparatus such as circuit board, it often needs to undertake a package structure process. Referring to Fig.1, an outward electric leadframe is set on the surface of the chip 10 that has a plurality of soldering points 101. The leadframe will form a plurality of leads 20, and a metal conductive line 30 is soldered between the selected surface of these leads 20 and these soldering points 101, such that a package consisted of the chip 10 and leads 20 can be formed by a sealant 40, and only the respective other end of every lead 20 is left outside the sealant 40 in advance for the application of soldering with other electric devices such as circuit boards.

As can be seen from the above description, before a conventional chip being applied in other electric devices such as circuit boards, it must undertake complicated package processes and use precise and expensive machines and molding apparatuses to package it. Consequently, in addition to resulting that unable to efficiently reduce the cost of manufacture and use, it also limits the application flexibility of the chip. For example, we can not randomly replace a chip to attain the benefit of expanding and altering, or we can not make a chip randomly match different circuit soldering points (such as soldering points of a circuit board surface), we even have to discard the whole circuit board only due to one chip being difficult to replace. Therefore, the implementation of the traditional package structure is neither reasonable nor practical.

### SUMMARY OF THE INVENTION

The present invention aims at providing the design for a chip assembling structure and socket, such that packaging processes and equipment can be avoided through this innovative assembling structure design consisting of the socket and the combination of the socket and chips, therefore reducing the cost for manufacture and utilization, as well as making it more flexible to replace chips or sockets.

With reference to the above objective, the present invention relates to form a chip assembling structure by use of semiconductor chips that contain multiple contacts and integrated circuit elements and a single socket. Wherein, said socket consists of either a single or a combination of insulating housings with at least one receiving face which is completely open or can be freely opened, which contain the contact ends of multiple transition media for matching the contacts of the chips, and extend each transition medium to form soldering terminals (or plug terminals) on the pre-selected panel of the receiving face, thereby enabling the flexible applications of any assembling and disassembling along with semiconductor chips, as well as eliminating the high cost packaging process.

### BRIEF DESCRIPTION OF THE DRAWINGS

Fig. 1 is a schematic diagram showing the conventional packaging structure of chips.
Fig. 2 is a schematic diagram showing the implementation of the receiving face formed in a recession according to the present invention.
Fig. 3 is a schematic diagram showing the assembly of the receiving face implemented in a recession according to the present invention.
Fig. 4 is a schematic diagram showing the implementation of the receiving face implemented on a protruding plane according to the present invention.
Fig. 5 is a schematic diagram showing the implementation of the receiving face implemented on the flat of the socket according to the present invention.
Fig. 6 is a schematic diagram showing the implementation of the transition media's soldering terminals according to the present invention.
Fig. 7 is a schematic diagram showing the implementation of the transition media's soldering terminals according to the present invention.
Fig. 8 is a schematic diagram showing the implementation of the transition media's soldering terminals according to the present invention.
Fig. 9 is a schematic diagram showing the implementation state of the step-like recession according to the present invention.
Fig. 10 is a schematic diagram showing the implementation state of multiple recessions according to of the present invention.

### DETAILED DESCRIPTION OF THE PREFERRED EMBODIMENTS

Herein below, the structural features and other functions, objectives of the present invention are described in details with reference to the embodiments illustrated in the attached drawings:
With reference to Fig. 2, the present invention relates to the design of "chip assembling structure and socket" that applies to a diversity of chips. In details, the chip's assembling structure and socket design consists of a chip 1 and a socket 2, wherein:
Chip 1 is carved from silicon, gallium arsenide, or other semiconductor materials, where multiple contacts 11 and specially designed integrated circuit elements (not shown) are positioned on the pre-selected face. The specific embodiments of the chip can include, but not limited to, memory chips such as DRAM, SRAM, SDRAM, Flash, DDR or Rambus, etc., microprocessors, logical or RF (Radio Frequency) chips, etc;

Socket 2 consists of either a single or a combination of insulating housings with one receiving face 21 that is completely open or can be freely opened at the pre-selected location for placing chips 1. Said socket 21 contains multiple contact ends 221 of the conductive transition media 22 that match plural contacts 11 on the chips. These ends serve to extend each transition medium 22 to and thus create soldering terminals 222 (or plug terminals) on the pre-selected surface for the socket 2;

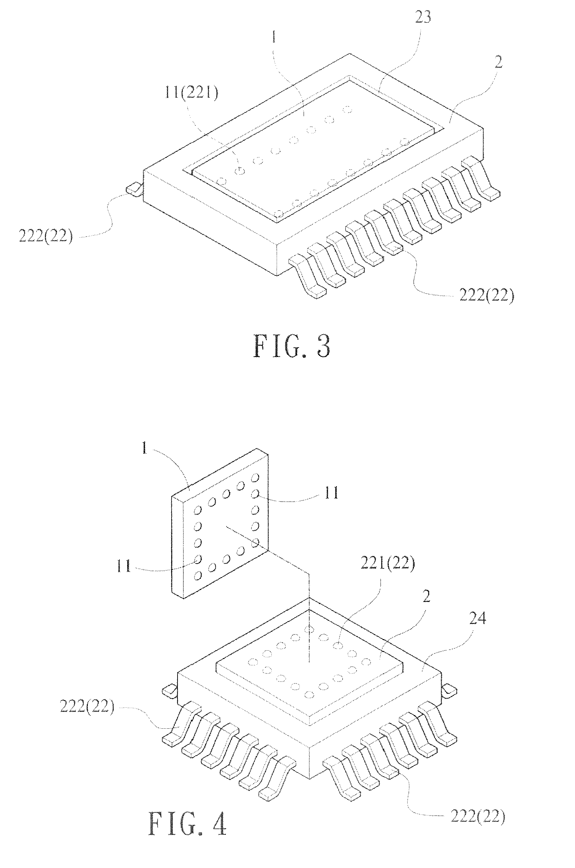

Thereby, with reference to Fig. 3, when placing a particular chip 1 on the receiving face 21 of the socket 2, and connecting the multiple contacts 11 on the pre-selected face of the chip 1 to the transition medium 22 contact ends 221 on the receiving face 21, the chip assembling structure for flexible utilization and eliminating the packaging process of the present invention is then realized.

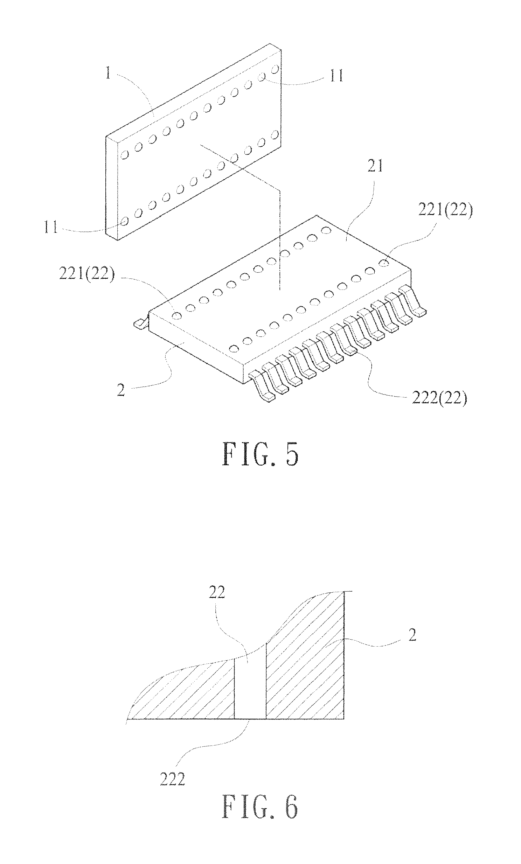

According to the present invention, the completely open or free opening receiving face 21 of the socket 2 can be implemented in several forms: a recession 23 on the pre-selected terminal face of the socket 2, utilizing its bottom face as said receiving face 21, on which multiple transition media 22's contact ends 221 are positioned in order, thereby forming an assembly connection with the chip 1 (as shown in Fig. 2 and 3); or a protruding plane 24 on the pre-selected terminal face of the socket 2, utilizing its terminal face as said receiving face 21, on which multiple transition media 22's contact ends 221 are positioned in order, thereby forming an assembly connection with the chip 1 (as shown in Fig. 4); or just a flat surface on the socket 2, utilizing this surface as said receiving face 21, on which multiple transition media 22's contact ends 221 are positioned in order, thereby forming an assembly connection with the chip 1 (as shown in Fig. 5). As described above, the receiving face 21 of the present invention is by far not restricted to only one form.

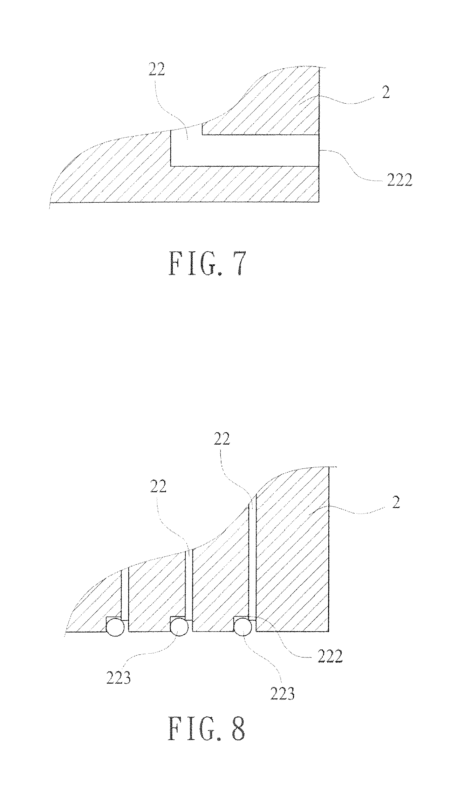

Next, said multiple transition media 22 of the socket 2 may be made of metallic structural materials and fixed to any pre-selected locations on the socket 2. When extended to the receiving face 21, their corresponding contact ends 221 can be implemented as fixed contacts, flexible contacts, or in any other structural forms that are able to come in contact with the multiple contacts 11 on the chip 1 (as shown in Fig. 2 to 5); As for the soldering terminals 222 of the multiple transition media 22 extended outside of socket 2's pre-selected face, various implementations are adopted: legs projecting from the sides or bottom of the socket 2 (as shown in Fig. 2 to 5), at least one plane on the exterior of socket 2's sides or bottom (as shown in Fig. 6 and 7), or any other structural forms that are able to extend outside the socket and sufficient for contact purposes. For example, the soldering terminals 222 illustrated by Fig. 8 are slightly withdrawn from the socket 2, however adequate external contacts are still made present by the tin balls 223 held at these terminals; In summary, any structural forms that enable complete match or partial match between the structural contact ends 221 of multiple transition media 22 and chip 1's contacts 11, as well as allow soldering terminals 222 to connect with other equipment, can be implemented within the field of the present invention.

With the technical measures revealed by the present invention, it is not only possible to pre-make a special socket 2 corresponding to chips of particular functions, such that assembly is realized through the complete match between the contact ends 221 and the contacts 11, but a socket 2 that applies to various chips can also be produced in advance, such that assembly is achieved by the selective partial match between the contact ends 221 and the contacts 11; it is therefore clear that in addition to avoid the conventional complicated packaging process of chips (for example, the elimination of the routing process) and the use of expensive packaging machinery, thus effectively reducing the cost for manufacture as well as utilization, the present invention also allows for flexible applications, specifically matching different chips 1 with the same socket 2, or matching the same chip 1 with various sockets 2, etc. through the socket 2's complete open or free opening receiving face 21 and the diverse structural forms of the multiple contact ends 221 on the receiving face 21. For example, in order to meet the different application demands, one can replace the socket when the number of contacts of the corresponding circuit board or other equipment changes, or utilize the socket 2 as a test jig, or integrate the socket 2 with already packaged chips, therefore improving the practicality of chips' conventional fixing and packaging technique.

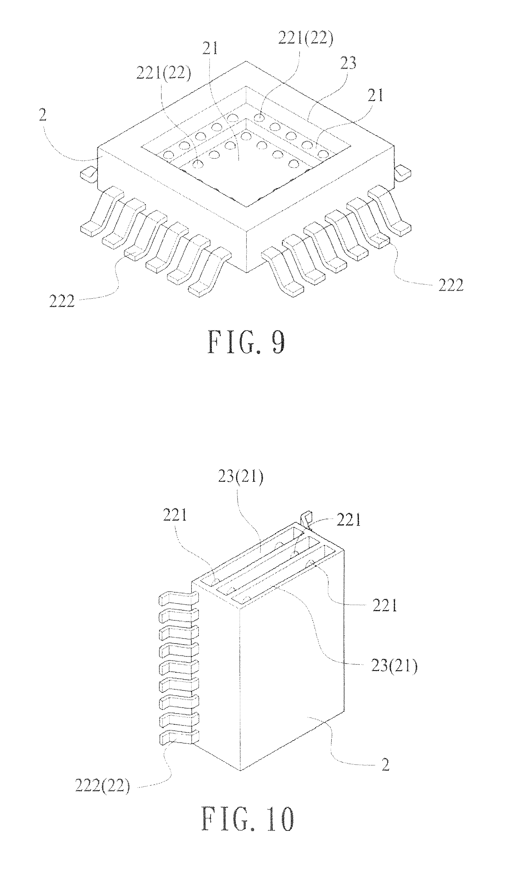

Another point to take into consideration is that said socket 2 is not restricted to integrate with only one chip 1. Namely, the structural form of said recession 23 can be implemented in a step-like pattern 23 (as shown in Fig. 9), where each step layer is utilized as said receiving face 21, on which the structural contact ends 221 of said multiple transition media 22 are placed, allowing a number of chips 1 to be stacked in the step-like recession 23; Furthermore, another alternative is to set multiple recessions 23 on the socket 2 (as shown in Fig. 10), selecting its bottom or sides as said receiving face 21, on which the structural contact ends 221 of said multiple transition media 22 are located, so as to allow a number of chips 1 to be randomly inserted. It is thus evident that in addition to achieve the above effects, the present invention can be implemented to further save space and reduce cost.

In summary, the present invention of "chip assembling structure and socket" has been proved to be both practicable and creative, with the invention's undoubtedly innovative embodiments combined with the perfect realization of the design goals through functionality, reasonable improvement is thus evidently traced. It is therefore decided to apply for an innovation patent according to related legal regulations. It is with great honor and sincere appreciation to have the esteemed patent bureau approve the present invention upon detailed review.

## Claims

1. A chip assembling structure, comprising: chip (1), wherein multiple contacts (11) are set on pre-selected surfaces; socket (2), wherein a n open receiving face (21) is located at the pre-selected area on the housing for placing chips (1), multiple contact ends (221) of the transition media (22) for matching multiple contacts (11) of chips (1) are implemented on the receiving face (21), and extend each transition medium (22) to form exposing soldering terminals (222) on the pre-selected surface of the socket (2); thereby, allowing randomly selected chips (1) to be placed on the socket's receiving face (21), so that the multiple chip contacts (11) are able to come in contact with the receiving face (21) of each transition medium (22), thus forming the chip assembling structure for any assembling application.

2. The chip assembling structure as set forth in claim 1, wherein, said socket (2) may implement at least one recession (23) on the pre-selected terminal face, and any of its face can be utilized as said receiving face (21).

3. The chip assembling structure as set forth in claim 1, wherein, said socket (2) may implement at least one protruding plane (24) on the pre-selected terminal face, and any of its side face can be utilized as said receiving face (21).

4. The chip assembling structure as set forth in claim 1, wherein, the receiving face (21) may consist of a flat housing with a plane thereof that can be utilized as said receiving face (21).

5. The chip assembling structure as set forth in claim 1, wherein, said contact ends (221) of the transition media (22) extended along the receiving face (21) are fixed contacts, flexible contacts, or any other structural forms that are able to come in contact with the multiple contacts (11) of the chips (1).

6. The chip assembling structure as set forth in claim 1, wherein, the soldering terminals (222) of the transition media (22) are in the form of legs projecting from the socket (2).

7. The chip assembling structure as set forth in claim 1, wherein, the soldering terminals (222) of the transition media (22) are in the form of at least a plane exposing on the socket's pre-selected face.

8. The chip assembling structure as set forth in claim 1, wherein, the soldering terminals (222) of the transition media (22) are slightly withdrawn from the socket (2), with soldering side that hold tin balls (223) being used to serve as exposing parts.

9. A chip socket, it is a socket (2) which can be assembled freely with chips (1) and possesses the following characteristic: open receiving faces are located at the pre-selected area on the socket, multiple contact ends (221) of the transition media (22) are implemented on the receiving face (21), and extend each transition medium (22) outside of the socket's pre-selected faces to form an exposing soldering terminal (222).
